# EUROPEAN PATENT SPECIFICATION

(11) **EP 4 644 918 B1**
(45) Date of publication and mention of the grant of the patent: **07.10.2026**
(21) Application number: 25160520.0
(22) Date of filing: 27.02.2025
(51) Int. Cl.: G01R 27/26, G01R 27/08, G01R 27/16

(54) **MEASUREMENT OF LOAD CAPACITANCE OR IMPEDANCE IN HIGH-VOLTAGE DC POWER SUPPLIES**
MESSUNG DER LASTKAPAZITÄT ODER IMPEDANZ IN HOCHSPANNUNGSGLEICHSTROMVERSORGUNGEN
MESURE DE LA CAPACITÉ DE CHARGE OU DE L'IMPÉDANCE DANS DES ALIMENTATIONS ÉLECTRIQUES À COURANT CONTINU HAUTE TENSION

(30) Priority: 29.04.2024 US 202418649515
(43) Date of publication of application: 05.11.2025
(73) Proprietor: Spellman High-Voltage Electronics Corporation, Hauppauge NY 11788 (US)
(72) Inventor: SEVEAU, Jean-Michel, Pullborough (GB)
(74) Representative: Gill Jennings & Every LLP

(56) References cited:
- CN-B- 102 841 258
- US-A1- 2012 098 553
- US-A1- 2021 011 067

## Description

### CROSS-REFERENCE TO RELATED APPLICATIONS

None

### FIELD OF THE INVENTION

The disclosure relates generally electric power supplies adapted for generating a direct current (DC) high-voltage, which are capable of monitoring the impedance or capacitance of loads connected to the power supplies. The disclosure relates more particularly to such electric power supplies that are suitable for use with electrostatic chucks.

### BACKGROUND OF THE INVENTION

In semiconductor and liquid crystal panel manufacturing processes, vacuum chucks and mechanical chuck systems have conventionally been used to secure the substrate for handling. However, due to the effects of adsorption, distortion and a requirement for improved reliability, chucks that utilize electrostatic force have been widely adopted in today's generation of semi fab equipment to overcome these limitations.

An electrostatic chuck ("e-chuck") consists of a platen with surface electrodes which are biased with high voltage to set up an electrostatic force between the platen and the wafer. Two types of electrostatic chucks are available: the Coulomb and Johnsen-Rahbek ("J-R") types. These are distinguished by their dielectric characteristics and, therefore, the way the clamping force is generated. A Coulomb chuck functions like a conventional dielectric capacitor. The J-R type has a large but finite resistance, so current flows through it and the substrate when the surfaces are in close contact and voltage is applied. Charge accumulates at the interface between substrate and dielectric which provides the clamping force.

In addition, different configurations of electrodes (or poles) on the chuck are used to get different characteristics. Monopolar, bipolar (two poles) and multipolar chucks (including 6 phase hexapolar types) are available depending on the application.

Known power supplies are provided for the complete range of e-chucks. The known power supplies have features that include:
high-voltage bipolar outputs (positive/negative),
output polarity reversal functions for easier wafer chucking/de-chucking,
capability to detect the state of the wafer by capacitance measurement (Coulomb chucks) or current measurement (J-R chucks), and/or
analogue and digital interfaces for easy integration into a variety of systems.

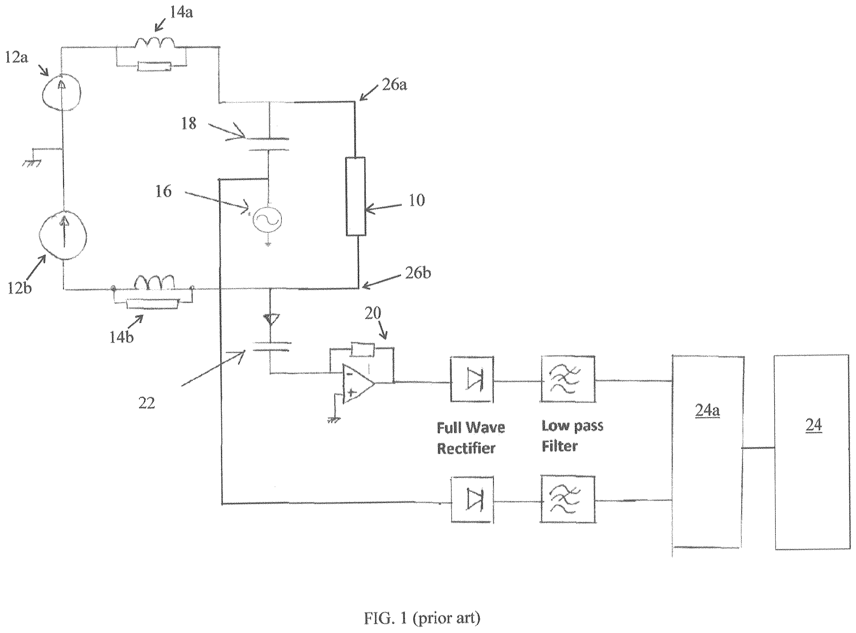

For example, a known power supply suitable for use with a Coulomb chuck is illustrated is FIG. 1. In this example, the power supply is bipolar and comprises two terminals 26a and 26b. A load 10, for example, a Coulomb-type electrostatic chuck, is shown connected between the two terminals 26a and 26b. In use, each of electric generators 12a and 12b generates a direct current (DC) high-voltage that is applied to the load 10.

The power supply shown in FIG. 1 comprises a sinewave oscillator 16. In use, the sinewave oscillator 16 generates a sinusoidal voltage at a predetermined frequency. The sinewave oscillator 16 is connected to a first lead of the capacitor 18 and the second lead of the capacitor 18 is connected to the terminal 26a. The sinusoidal voltage applied to the first lead of the capacitor 18 causes an oscillating current to flow from the ground. A first portion of this oscillating current may flow back to the ground via the blocking inductor 14a and the electric generator 12a. A second portion of this oscillating current may flow back to the ground via the load 10, the capacitor 22 and the current-to-voltage converter 20. A third portion of this oscillating current may flow back to the ground via the load 10, the blocking inductor 14b, and the electric generator 12b.

The first portion of the oscillating current is ideally negligible compared to the second portion of the oscillating current.. In contrast, the second portion of the oscillating current is almost equal to the alternating current (AC) flowing through the load 10.. Similar to the first portion, the third portion of the oscillating current is also ideally negligible compared to the second portion of the oscillating current..

Because load 10, blocking inductor 14a and coupling capacitor 18 are placed in parallel, an oscillating potential results at one lead of the load 10. Similarly, because load 10, blocking inductor 14b and coupling capacitor 22 are placed in parallel, an oscillating potential results at the other lead of the load 10.

The power supply shown in FIG. 1 comprises a first sensor that measures the magnitude of the second portion of the oscillating current, which is, as previously mentioned, almost equal to the AC flowing through the load 10. The first sensor includes the current-to-voltage converter 20, a full wave rectifier, a lowpass filter, and a channel of an analog-to-digital converter ADC 24a. The first sensor cannot measure phases.

The power supply shown in FIG. 1 comprises a second sensor that measure the magnitude of the sinusoidal voltage generated by the sinewave oscillator 16. The second sensor includes a full wave rectifier, a lowpass filter, and a channel of the ADC 24a. The second sensor cannot measure phases.

The power supply shown in FIG. 1 does not directly measure the voltage at the terminal 26, and the oscillation voltage caused by the flow of first and second portions of the oscillating current through the capacitor 18 can only be estimated.

The power supply shown in FIG. 1 comprises a micro-controller 24 that is programmed to estimate the capacitance of the load 10 from the digitized magnitude of the sinusoidal voltage, the magnitude of the AC current flowing through the load 10 (which is approximated by the magnitude of the second portion of the oscillating current) and the values of capacitors 18 and 22. **In** some cases, however, the estimate of the capacitance of the load 10 may lack accuracy and/or precision..

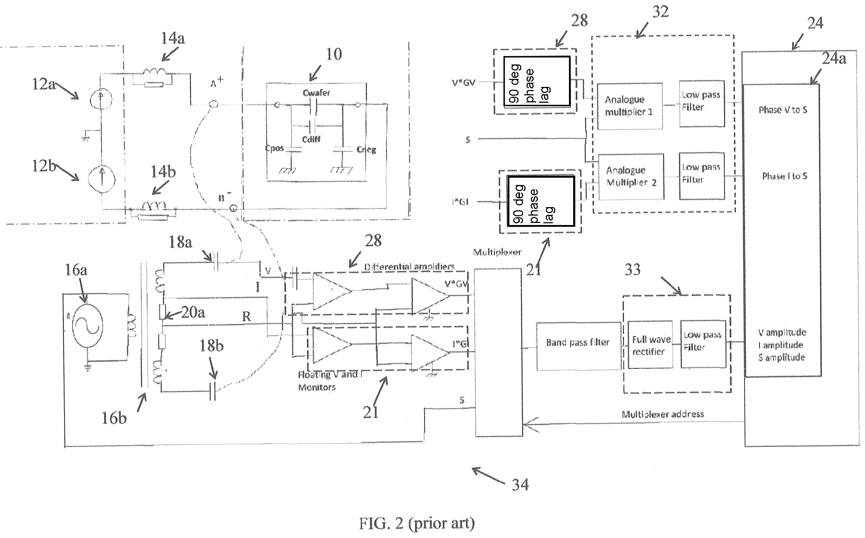

The power supply shown in FIG. 2 is bipolar. It has a terminal A⁺ and a terminal B⁻, each connected to the load 10. It comprises electric generators 12a and 12b, and a monitor 34.

**In** this example, the monitor 34 comprises a sinewave oscillator 16a and a transformer 16b for injecting a sinusoidal signal via capacitors 18a and 18b in a differential manner. Note that the circuit consisting of the sinewave oscillator 16a and the transformer 16b can be considered to form a sinewave oscillator in itself too: it generates the two voltage signals at the leads of the two secondary coils of the transformer 16b, and a third voltage signal R (e.g., a reference signal) between the two resistors connected in series with the two secondary coils.. Blocking inductors 14a and 14b are used to increase the impedance of the electric generators 12a and 12b at the sinewave oscillator 16a frequency.

As a result of the combined actions of the sinewave oscillator consisting of the sinewave oscillator 16a and the transformer 16b, the capacitors 18a and 18b, and the blocking inductors 14a and 14b, a first, small, portion of an alternating current (i.e., without DC component) flows through the sinewave oscillator 16a/16b (including through the resistor 20a), the capacitor 18a, the blocking inductor 14a, the electric generators 12a and 12b, the blocking inductor 14b, the capacitor 18b and back to the sinewave oscillator 16a/16b. A second, larger, portion of the alternating current flows through the sinewave oscillator 16a/16b (including through the resistor 20a), the capacitor 18a, the load 10, the capacitor 18b, and back to the sinewave oscillator 16a/16b.

The alternating current flowing through the load 10 is measured using the floating sensor 21, which measures the voltage drop across the resistor 20a. The sensor 21 includes a voltage follower, a differential amplifier, and a filter (either the bandpass filter connected to signal I*GI and to circuit 32 and/or the bandpass filter connected to signal I*GI via a multiplexer and to circuit 33). This estimation can be used as the current flowing through the load 10 when the first and third portions of the alternating current are sufficiently small compared to the second portion, so that the voltage drop across the resistor 20a is mainly caused by the alternating current flowing through the load 10 (i.e., the second portion of the alternating current).

The AC component of the voltage at the terminal A⁺ is measured via the floating sensor 28, which includes a feedback capacitor, a voltage follower, a differential amplifier, and a filter (either the bandpass filter connected to signal V*GV and to circuit 32 or the bandpass filter connected to signal V*GV via a multiplexer and to circuit 33). The AC component of the voltage at the terminal B⁻ is assumed to be the opposite of the AC component of the voltage at the terminal A⁺.

Voltage V*GV, source S and current I*GI signals are fed to a demodulator 32, which provides an accurate way of calculating the phase of current and voltage. In this example, the demodulator 32 includes a pair of analog multipliers, each connected in series with a lowpass filter. Using V*GV, I*GI, and S analog signals, the demodulator 32 generates two analog signals: ½ |V*GV| . |S| x COS φ(V*GV/S), and ½ |I*GI| . |S| x COS φ(I*GI/S).

In this example, the monitor 34 also includes a rectifier 33, which, after lowpass filtering, generates one of the three analog signals: |V*GV|, |I*GI|, and |S|, depending on the status of the multiplexer.

A micro-controller 24 digitizes the two analog signals generated by the demodulator 32 and the three analog signals generated by the rectifier 33. The micro-controller 24 has known equations programmed in its firmware for calculating the capacitance/impedance of the load 10 from the digital data. In some cases, however, injecting a sinusoidal signal via capacitors 18a and 18b in a differential manner in a bipolar system may lack flexibility power supplies to be used with certain types of e-chucks.

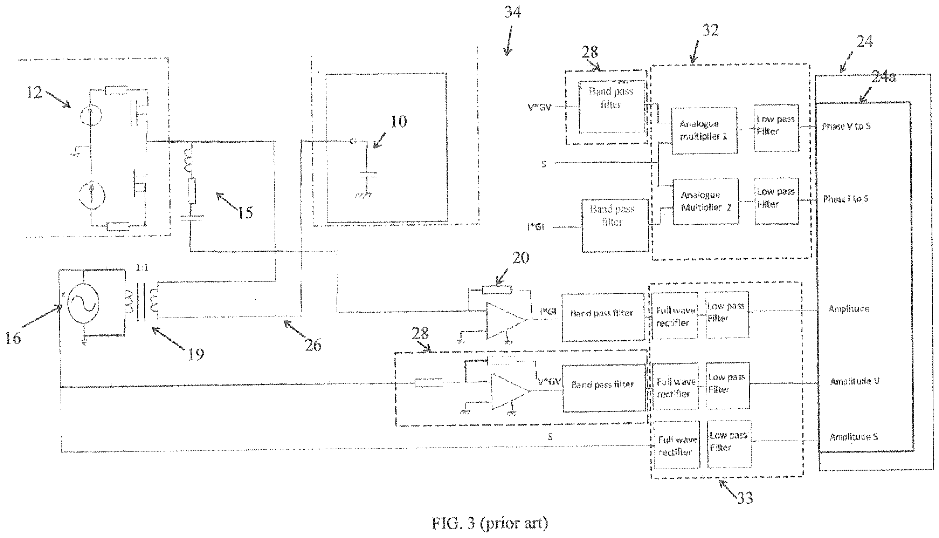

The power supply shown in FIG. 3 represents one phase of a multipolar system. It has a terminal 26 connected to the load 10. It comprises an electric generator 12 and a monitor 34.

In this example, the monitor 34 comprises a sinewave oscillator 16 for adding a sinusoidal signal via a transformer 19 placed in series with the load. An RLC circuit 15, resonant at the frequency of the sinusoidal signal, is used to present a very low impedance path to ground to the injected AC current.

As a result of the combined actions of the sinewave oscillator 16, the transformer 19, and the RLC circuit 15, a first, small, portion of an alternating current (i.e., without DC component) flows in the HV generator 12.. A second, larger, portion of the alternating current is supplied from the ground by the current-to-voltage converter 20 and flows through the RLC circuit 15, the secondary coil of the voltage transformer 19, the load 10 and back to the ground.

The alternating current flowing through the load 10 is estimated using a sensor which includes the current-to-voltage converter 20 and a filter (either the 90deg lag filter connected to signal I*GI and to circuit 32 and/or the bandpass filter connected to signal I*GI and to circuit 33). This estimation can be used as the current flowing through the load 10 when the first portion of the alternating current is sufficiently small compared to the second portion.

The AC component of the voltage at the terminal of load 10 is estimated via the sensor 28, which is adapted for monitoring a voltage drop across the primary coil of the voltage transformer 19. The voltage sensor 28 includes an amplifier, and a filter (either the 90deg lag filter connected to signal V*GV and to circuit 32 and/or the bandpass filter connected to signal V*GV and to circuit 33). This estimation can be used as the AC component of the voltage at the terminal of load 10 by using the ratio (e.g., 1:1) of voltage transformation of the voltage transformer 19.

Voltage V*GV, source S and current I*GI signals are fed to a demodulator 32, which provides an accurate way of calculating the phase of current and voltage. In this example, the demodulator 32 includes a pair of analog multipliers, each connected in series with a lowpass filter. Using V*GV, I*GI, and S analog signals, the demodulator 32 generates two analog signals: ½ |V*GV|. |S| x COS φ(V*GV/S), and ½ |I*GI| . |S| x COS φD(I*GI/S).

In this example, the monitor 34 also includes a rectifier 33, which, after lowpass filtering, generates three analog signals: |V*GV|, |I*GI|, and |S|.

A micro-controller 24 digitizes the two analog signals generated by the demodulator 32 and the three analog signals generated by the rectifier 33. The micro-controller 24 has known equations programmed in its firmware for calculating the capacitance/impedance of the load 10 from the digital data.

The document US 2021/011067 A1 discloses an arrangement for measuring the impedance properties of a load using load analysis signals wherein a transformer which includes at least one primary winding, and at least one secondary winding is provided. The at least one primary winding is coupled in series between a direct-current (DC) power supply and the load. A variable alternating-current (AC) voltage generator is coupled in-series to the at least one secondary winding, and is configured generate at least one load analysis signal for injection into the load. The impedance properties of the load may be determined for different frequencies in the load analysis signals.

In view of the foregoing, there is a need in the art for a power supply capable of monitoring the impedance or capacitance of a load connected to the power supply.

### SUMMARY

The disclosure describes power supplies capable of monitoring the impedance or capacitance of a load connected to the power supply. The power supplies comprise a current sensor adapted for generating a first alternating signal indicative of an oscillating current through the load, a voltage sensor adapted for generating a second alternating signal indicative of an oscillating voltage across the load, and a source conductor adapted for transmitting a third alternating signal indicative of the sinusoidal voltage generated by a sinewave oscillator. A micro-controller is coupled to the first alternating signal, the second alternating signal, and the third alternating signal. The micro-controller is adapted for computing the impedance or capacitance of the load by using digital data derived from the first alternating signal, the second alternating signal, and the third alternating signal.

The invention according to respective claims 1 and 6 is susceptible to various modifications and alternative forms, and specific embodiments thereof are shown by way of example in the drawings and description. It should be understood, however, that the drawings and description are not intended to limit the invention to the particular form disclosed, but on the contrary, the intention is to cover all modifications and alternatives available to a person having ordinary skill in the art

### BRIEF DESCRIPTION OF THE DRAWINGS

For a more detailed description of the embodiments of the disclosure, reference will now be made to the accompanying drawings, wherein:
FIG. 1 is a schematic of a known bipolar power supply suitable for use with a Coulomb chuck;
FIG. 2 is a schematic of a known bipolar power supply suitable for use with a Coulomb chuck;
FIG. 3 is a schematic of a known one phase or one of multiple phases of a power supply suitable for use with a Coulomb chuck; and
FIG. 4 is a schematic of one phase or one of multiple phases of a power supply suitable for use with a Coulomb chuck.

### DETAILED DESCRIPTION

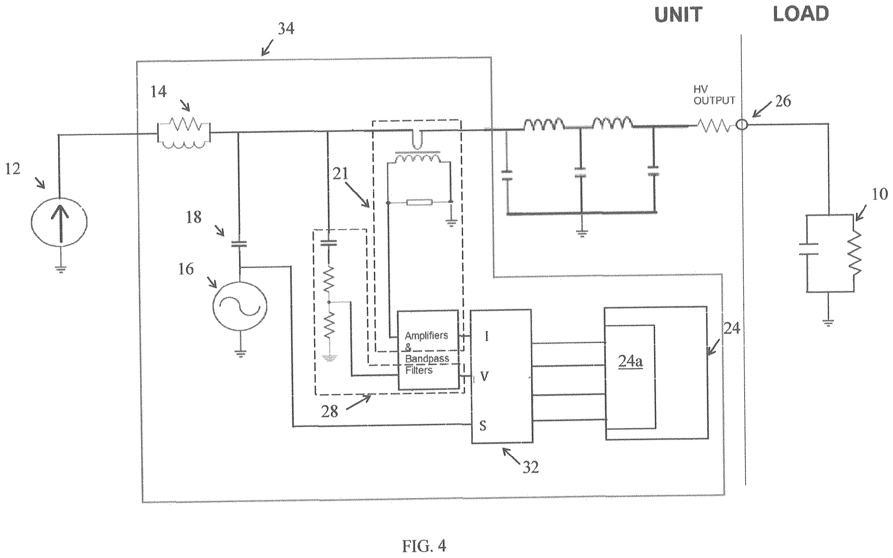

FIG. 4illustrates preferred embodiments of a power supply having a monitor capable of causing voltage oscillations across a load connected to the power supply and current voltage oscillations into the load from a predetermined sinusoidal signal. The monitor is also capable of measuring, exactly or approximately,
the sinusoidal signal,
the amplitude and the phase shift relative to the sinusoidal signal of the voltage caused by the sinusoidal signal, and
the amplitude and the phase shift relative to the sinusoidal signal of the current caused by the sinusoidal signal.
The monitor calculates the capacitance or impedance of the load based on the measurements.

The preferred embodiments may provide simpler and more efficient ways of calculating the capacitance or impedance of the load than the power supplies illustrated in FIGs. 1-3.

The power supply shown in FIG. 4 is unipolar or one of multiple phases. It has a terminal 26 connected to the load 10. It comprises an electric generator 12 and a monitor 34.

In this example, the monitor 34 comprises a sinewave oscillator 16 for injecting a sinusoidal signal via a capacitor 18. A blocking inductor 14 is used to increase the impedance of the electric generator 12 at the sinewave oscillator 16 frequency.

As a result of the combined actions of the sinewave oscillator 16, the capacitor 18, and the blocking inductor 14, a first, small, portion of an alternating current (i.e., without DC component) flows through the sinewave oscillator 16, the capacitor 18, the blocking inductor 14, the electric generator 12, and back to the ground. A second, larger, portion of the alternating current, flows through the sinewave oscillator 16, the capacitor 18, the load 10, and back to the ground. A third, small, portion of the alternating current flows through the sinewave oscillator 16, the capacitor 18, a sensor 28, and back to the ground.

The second portion of the alternating current is measured using a sensor 21, which includes a current transformer (also providing high-voltage insulation), an amplifier, a filter. This second portion of the alternating current is the exact alternating component of the current flowing through the load 10.

The AC component of the voltage at the terminal 26 is measured via the sensor 28, which includes a capacitor, a voltage divider, an amplifier, and a filter. This measurement can be used as the AC component of the voltage at the terminal 26 as the voltage differential caused by the primary coil of the current transformer of the sensor 21 is negligible.

Voltage V, source S and current I signals are fed to a quadrature demodulator 32, which provides an accurate way of calculating amplitude and phase of current and voltage. Using analog **V,** I, and S signals, the demodulator 32 generates four analog signals: |V| . COS φ(V/S), |V|. SIN φ(V/S), |I| . COS φ(I/S) and |I| . SIN φ(I/S).

A micro-controller 24 digitizes the four signals with an ADC 24a. The micro-controller 24 has known equations programmed in its firmware for calculating the capacitance/impedance of the load 10 from the digital data.

Multiple monitors 34 can be used in multipolar power supplies having an architecture similar to the power supply shown in FIG. 4, each measuring capacitances/impedances to ground on multiple terminals. **In** such cases, differential capacitances/impedances can also be calculated, for example, by using a combination of different sensors on different terminals.

**In** addition to the foregoing, the disclosure also contemplates at least the following embodiments 1-14. It should be noted that any element of any of these embodiments may further include details related to this element that are disclosed in a paragraph or Figure describing the preferred embodiments without including details of other elements that are disclosed in the same or other paragraph or Figure.

### Embodiment 1

Embodiment 1 is a power supply capable of monitoring the impedance or capacitance of a load connected to the power supply.

The power supply includes at least a first terminal connectable to the load. The power supply also includes at least one electric generator that generates a direct current (DC) high-voltage between first and second terminals.

If only one electric generator is used, the power supply is unipolar. In such a case, the first terminal of the electric generator is connected to the first terminal of the power supply, and the second terminal of the electric generator is connected to the ground.

If two electric generators are used, the power supply can be bipolar. In such a case, the power supply further includes a second terminal. The first terminal of the first electric generator is again connected to the first terminal of the power supply, and the second terminal of the first electric generator is again connected to the ground. In addition, the first terminal of the second electric generator may be connected to ground, and the second terminal of the second electric generator is connected to the second terminal of the power supply.

The power supply includes a monitor that comprises a inject circuit, a boost circuit, and a sinewave oscillator. When the power supply is bipolar, the monitor may comprise another boost circuit.

The inject circuit is adapted for flowing an oscillating current between first and second terminals. The first terminal of the inject circuit is connected to the first terminal of the power supply, and the second terminal of the inject circuit is connected to the ground or, if provided, the second terminal of the power supply. As such, the inject circuit is connected to the electric generator(s) in parallel with the load.

The boost circuit is adapted for generating an oscillating voltage between first and second terminals. The first terminal of the boost circuit is connected to the first terminal of the first electric generator and the second terminal of the boost circuit is connected to the first terminal of the power supply. The other boost circuit, if provided, may be connected between the second terminal of the second electric generator and the second terminal of the power supply. As such, the boost circuit(s) is(are) connected to the electric generator(s) in series with the load.

The sinewave oscillator is adapted for generating a sinusoidal voltage at a predetermined frequency. In contrast to a voltage having a different frequency spectrum, a sinusoidal voltage is preferred in cases where the load has an impedance that is frequency dependent, as is the case of the impedance of a capacitive circuit (e.g., an e-chuck). As such, the load response to a sinusoidal signal at a predetermined frequency is easier to interpret. However, the sinewave oscillator may be adapted for sequentially generating a sinusoidal voltage at a first predetermined frequency and then a sinusoidal voltage at a second, different predetermined frequency, etc. The sinewave oscillator is coupled to one of the inject circuit and the boost circuit. When the sinewave oscillator is coupled to the inject circuit, it drives the oscillating current, which flows through the load. The boost circuit(s) passively generate(s) the oscillating voltage, which tends to counteract the oscillating current so that less oscillating current flows through the electric generator(s). When the sinewave oscillator is coupled to the boost circuit, it drives the oscillating voltage, which is applied to the load. The inject circuit(s) passively generate the oscillating current, which tends to counteract the oscillating current that is generated by the load in response to the oscillating voltage and would otherwise flows through the electric generator(s) so that, again, less oscillating current flows through the electric generator(s).

The power supply further includes a current sensor, a voltage sensor, and a source conductor, which each generates alternating signals used by a micro-controller for computing the impedance or capacitance of the load.

The current sensor is adapted for generating a first alternating signal indicative of the oscillating current. Generally, the current sensor may be adapted to convert a current flowing through the inject circuit or through the first terminal of the power supply into a voltage.

The voltage sensor is adapted for generating a second alternating signal indicative of the oscillating voltage. Generally, the voltage sensor may not be sensitive to the DC high-voltage generated by the electric generator(s).

The source conductor is adapted for transmitting a third alternating signal indicative of the sinusoidal voltage generated by the sinewave generator.

The micro-controller may be integral to the power supply or may be provided as a separate module. The micro-controller is coupled to the first alternating signal, the second alternating signal, and the third alternating signal. Optionally, the micro-controller may be sequentially coupled to the first, second, and third signals via a multiplexer. Alternatively, the micro-controller may be simultaneously coupled to the signals. The coupling of the micro-controller to the signals may be a direct digitized communication of the three alternating signals to the micro-controller, or an indirect digitized communication of other signals derived from the three alternating signals to the micro-controller. For example, the other signals may be derived by analog demodulations, rectification, filtering (e.g., bandpass filtering at the predetermined frequency), or combinations thereof.

Furthermore, the micro-controller is adapted for computing the impedance or capacitance of the load from digital data derived from the first alternating signal, the second alternating signal, and the third alternating signal. Typically, the micro-controller may be programmable and the computation of the impedance or capacitance of the load may be pre-programmed to implement mathematical formula well known in the art.

Notably, the use of the third alternating signal or alternating signals derived from the third alternating signal may advantageously improve the accuracy and/or precision of the computation of the impedance or capacitance of the load, typically in the presence of noise in the direct current (DC) high-voltage.

## Claims

1. A power supply capable of monitoring the impedance or capacitance of a load (10) connected to the
power supply,
the power supply including:
a first terminal (26) connectable to the load, an electric generator (12) adapted for generating a direct current (DC) high-voltage between first and second terminals, wherein the first terminal of the electric generator is connected to the first terminal of the power supply and the second terminal of the electric generator is connected to the ground, and
a monitor (34),
the monitor comprising:
a inject circuit adapted for flowing an oscillating current between first and second terminals, wherein the first terminal of the inject circuit is connected to the first terminal of the power supply and the second terminal of the inject circuit is connected to the ground or to a second terminal of the power supply;
a boost circuit adapted for generating an oscillating voltage between first and second terminals, wherein the first terminal of the boost circuit is connected to the first terminal of the electric generator and the second terminal of the boost circuit is connected to the first terminal of the power supply;
a sinewave oscillator (16) adapted for generating a sinusoidal voltage at a predetermined frequency, wherein the sinewave oscillator has a terminal that is coupled to one of the inject circuit and the boost circuit;
a current sensor (21) adapted for generating a first alternating signal indicative of the oscillating current;
wherein the current sensor includes a transformer having: a primary coil in series between the boost circuit and the first terminal of the power supply and a secondary coil connected to an input of an inverting or non-inverting operational amplifier;
a voltage sensor (28) adapted for generating a second alternating signal indicative of the oscillating voltage;
a source conductor adapted for transmitting a third alternating signal indicative of the sinusoidal voltage; and
a micro-controller (24) coupled to the first alternating signal, the second alternating signal, and the third alternating signal,
wherein the micro-controller is adapted for computing the impedance or capacitance of the load by using digital data derived from the first alternating signal, the second alternating signal, and the third alternating signal.

2. The power supply of claim 1, wherein:
the inject circuit includes a coupling capacitor having one lead connected to the first terminal of the power supply;
the sinewave oscillator has a first terminal connected to another lead of the coupling capacitor and a second terminal connected to the ground or to the second terminal of the power supply,
the boost circuit includes a blocking inductor (14); and
the blocking inductor is connected between the first terminal of the electric generator and the coupling capacitor.

3. The power supply of claim 1, further comprising an analog demodulator (32) having inputs coupled
to the current sensor, the voltage sensor, and the source conductor,
the analog demodulator having outputs coupled to the micro-controller,
the analog demodulator being configured to analogically demodulate the first alternating signal and the second alternating signal relative to the third alternating signal.

4. The power supply of claim 3 wherein the analog demodulator includes a quadratic demodulator configured to generate four output signals:
the magnitude of the first alternating signal multiplied by the cosine of the phase of the first alternating signal relative to the third alternating signal,
the magnitude of the first alternating signal multiplied by the sinus of the phase of the first alternating signal relative to the third alternating signal,
the magnitude of the second alternating signal multiplied by the cosine of the phase of the second alternating signal relative to the third alternating signal, and
the magnitude of the second alternating signal multiplied by the sinus of the phase of the second alternating signal relative to the third alternating signal.

5. The power supply of claim 1, wherein the voltage sensor includes:
a lowpass or bandpass filter connected to the first terminal of the power supply and to the ground, and
an inverting or non-inverting operational amplifier having an input connected to the lowpass or bandpass filter.

6. A method of monitoring the impedance or capacitance of a load (10) connected to a power supply,
the power supply including a first terminal (26) connectable to the load, and an electric generator (12) adapted for generating a direct current (DC) high-voltage between first and second terminals, wherein the first terminal of the electric generator is connected to the first terminal of the power supply and the second terminal of the electric generator is connected to the ground, the method comprising:
providing the power supply with a monitor (34); and
causing the monitor to display or store digital data indicative of the impedance or capacitance of the load;
wherein the monitor includes:
a inject circuit adapted for flowing an oscillating current between first and second terminals, wherein the first terminal of the inject circuit is connected to the first terminal of the power supply and the second terminal of the inject circuit is connected to the ground or to a second terminal of the power supply;
a boost circuit adapted for generating an oscillating voltage between first and second terminals, wherein the first terminal of the boost circuit is connected to the first terminal of the electric generator and the second terminal of the boost circuit is connected to the first terminal of the power supply;
a sinewave oscillator (16) adapted for generating a sinusoidal voltage at a predetermined frequency, wherein the sinewave oscillator has a terminal that is coupled to one of the inject circuit and the boost circuit;
a current sensor (21) adapted for generating a first alternating signal indicative of the oscillating current;
wherein the current sensor includes a transformer having: a primary coil in series between the boost circuit and the first terminal of the power supply and a secondary coil connected to an input of an inverting or non-inverting operational amplifier; a voltage sensor (28) adapted for generating a second alternating signal indicative of the oscillating voltage;
a source conductor adapted for transmitting a third alternating signal indicative of the sinusoidal voltage; and
a micro-controller (24) coupled to the first alternating signal, the second alternating signal, and the third alternating signal,
wherein the micro-controller is adapted for computing the impedance or capacitance of the load by using digital data derived from the first alternating signal, the second alternating signal, and the third alternating signal.

7. The method of claim 6, wherein:
the inject circuit includes a coupling capacitor having one lead connected to the first terminal of the power supply;
the sinewave oscillator has a first terminal connected to another lead of the coupling capacitor and a second terminal connected to the ground or to the second terminal of the power supply,
the boost circuit includes a blocking inductor (14); and
the blocking inductor is connected between the first terminal of the electric generator and the coupling capacitor.

8. The method of claim 6, further comprising an analog demodulator (32) having inputs coupled to the
current sensor, the voltage sensor, and the source conductor, the analog demodulator having outputs coupled to the micro-controller,
the analog demodulator being configured to analogically demodulate the first alternating signal and the second alternating signal relative to the third alternating signal.

9. The method of claim 8 wherein the analog demodulator includes a quadratic demodulator configured to generate four output signals:
the magnitude of the first alternating signal multiplied by the cosine of the phase of the first alternating signal relative to the third alternating signal,
the magnitude of the first alternating signal multiplied by the sinus of the phase of the first alternating signal relative to the third alternating signal,
the magnitude of the second alternating signal multiplied by the cosine of the phase of the second alternating signal relative to the third alternating signal, and
the magnitude of the second alternating signal multiplied by the sinus of the phase of the second alternating signal relative to the third alternating signal.

10. The method of claim 6, wherein the voltage sensor includes
a lowpass or bandpass filter connected to the first terminal of the power supply and to the ground, and
an inverting or non-inverting operational amplifier having an input connected to the lowpass or bandpass filter.

11. The method of claim 6, wherein the load is a Coulomb-type electrostatic chuck, the method further comprising clamping a semiconductor or liquid crystal panel by applying a direct current (DC) high-voltage to the chuck with the power supply.

## Patentansprüche

1. Stromversorgung, die in der Lage ist, die Impedanz oder Kapazität einer an die Stromversorgung angeschlossenen Last (10) zu überwachen,
wobei die Stromversorgung einschließt:
einen ersten Anschluss (26), der mit der Last verbunden werden kann,
einen elektrischen Generator (12), der zum Erzeugen einer Gleichstrom-(DC)-Hochspannung zwischen einem ersten und einem zweiten Anschluss angepasst ist, wobei der erste Anschluss des elektrischen Generators mit dem ersten Anschluss der Stromversorgung verbunden ist und der zweite Anschluss des elektrischen Generators mit Masse verbunden ist, und
einen Monitor (34),
wobei der Monitor umfasst:
eine Einspeiseschaltung, die zum Fließenlassen eines oszillierenden Stroms zwischen dem ersten und dem zweiten Anschluss angepasst ist, wobei der erste Anschluss der Einspeiseschaltung mit dem ersten Anschluss der Stromversorgung verbunden ist und der zweite Anschluss der Einspeiseschaltung mit der Masse oder mit einem zweiten Anschluss der Stromversorgung verbunden ist;
eine Boost-Schaltung, die zum Erzeugen einer oszillierenden Spannung zwischen dem ersten und dem zweiten Anschluss angepasst ist, wobei der erste Anschluss der Boost-Schaltung mit dem ersten Anschluss des elektrischen Generators verbunden ist und der zweite Anschluss der Boost-Schaltung mit dem ersten Anschluss der Stromversorgung verbunden ist;
einen Sinuswellenoszillator (16), der zum Erzeugen einer sinusförmigen Spannung mit einer vorgegebenen Frequenz angepasst ist, wobei der Sinuswellenoszillator einen Anschluss aufweist, der mit einer der Einspeiseschaltung und der Boost-Schaltung gekoppelt ist;
einen Stromsensor (21), der zum Erzeugen eines ersten Wechselsignals, das den oszillierenden Strom anzeigt, angepasst ist;
wobei der Stromsensor einen Transformator einschließt, der Folgendes aufweist:
eine Primärspule, die in Reihe zwischen der Boost-Schaltung und dem ersten Anschluss der Stromversorgung geschaltet ist, und
eine Sekundärspule, die mit einem Eingang eines invertierenden oder nicht invertierenden Operationsverstärkers verbunden ist;
einen Spannungssensor (28), der zum Erzeugen eines zweiten Wechselsignals, das die oszillierende Spannung anzeigt, angepasst ist;
einen Quell-Leiter, der zum Übertragen eines dritten Wechselsignals, das die sinusförmige Spannung anzeigt, angepasst ist; und
einen Mikrocontroller (24), der mit dem ersten Wechselsignal, dem zweiten Wechselsignal und dem dritten Wechselsignal gekoppelt ist,
wobei der Mikrocontroller zum Berechnen der Impedanz oder Kapazität der Last durch Verwendung digitaler Daten, die aus dem ersten Wechselsignal, dem zweiten Wechselsignal und dem dritten Wechselsignal abgeleitet werden, angepasst ist.

2. Stromversorgung nach Anspruch 1, wobei:
die Einspeiseschaltung einen Kopplungskondensator einschließt, der eine Leitung aufweist, die mit dem ersten Anschluss der Stromversorgung verbunden ist;
der Sinuswellenoszillator einen ersten Anschluss, der mit einer anderen Leitung des Kopplungskondensators verbunden ist, und einen zweiten Anschluss aufweist, der mit der Masse oder mit dem zweiten Anschluss der Stromversorgung verbunden ist,
die Boost-Schaltung eine Sperrinduktivität (14) einschließt; und
die Sperrinduktivität zwischen dem ersten Anschluss des elektrischen Generators und dem Kopplungskondensator geschaltet ist.

3. Stromversorgung nach Anspruch 1, weiter umfassend einen analogen Demodulator (32), der Eingänge aufweist, die mit dem Stromsensor, dem Spannungssensor und dem Quell-Leiter gekoppelt sind,
wobei der analoge Demodulator Ausgänge aufweist, die mit dem Mikrocontroller gekoppelt sind,
wobei der analoge Demodulator ausgebildet ist, um das erste Wechselsignal und das zweite Wechselsignal relativ zum dritten Wechselsignal analog zu demodulieren.

4. Stromversorgung nach Anspruch 3, wobei der analoge Demodulator einen quadratischen Demodulator einschließt, der ausgebildet ist, um vier Ausgangssignale zu erzeugen:
der Betrag des ersten Wechselsignals multipliziert mit dem Kosinus der Phase des ersten Wechselsignals relativ zum dritten Wechselsignal,
der Betrag des ersten Wechselsignals multipliziert mit dem Sinus der Phase des ersten Wechselsignals relativ zum dritten Wechselsignal,
der Betrag des zweiten Wechselsignals multipliziert mit dem Kosinus der Phase des zweiten Wechselsignals relativ zum dritten Wechselsignal, und
der Betrag des zweiten Wechselsignals multipliziert mit dem Sinus der Phase des zweiten Wechselsignals relativ zum dritten Wechselsignal.

5. Stromversorgung nach Anspruch 1, wobei der Spannungssensor einschließt:
ein Tiefpass- oder Bandpassfilter, das mit dem ersten Anschluss der Stromversorgung und mit der Masse verbunden ist, und
einen invertierenden oder nicht invertierenden Operationsverstärker, der einen Eingang aufweist, der mit dem Tiefpass- oder Bandpassfilter verbunden ist.

6. Verfahren zum Überwachen der Impedanz oder Kapazität einer an eine Stromversorgung angeschlossenen Last (10),
wobei die Stromversorgung einen ersten Anschluss (26), der mit der Last verbunden werden kann, und einen elektrischen Generator (12) einschließt, der zum Erzeugen einer Gleichstrom-(DC)-Hochspannung zwischen einem ersten und einem zweiten Anschluss angepasst ist, wobei der erste Anschluss des elektrischen Generators mit dem ersten Anschluss der Stromversorgung verbunden ist und der zweite Anschluss des elektrischen Generators mit der Masse verbunden ist, wobei das Verfahren umfasst:
Bereitstellen der Stromversorgung mit einem Monitor (34); und
Veranlassen, dass der Monitor digitale Daten anzeigt oder speichert, die die Impedanz oder Kapazität der Last anzeigen;
wobei der Monitor einschließt:
eine Einspeiseschaltung, die zum Fließenlassen eines oszillierenden Stroms zwischen dem ersten und dem zweiten Anschluss angepasst ist, wobei der erste Anschluss der Einspeiseschaltung mit dem ersten Anschluss der Stromversorgung verbunden ist und der zweite Anschluss der Einspeiseschaltung mit der Masse oder mit einem zweiten Anschluss der Stromversorgung verbunden ist;
eine Boost-Schaltung, die zum Erzeugen einer oszillierenden Spannung zwischen dem ersten und dem zweiten Anschluss angepasst ist, wobei der erste Anschluss der Boost-Schaltung mit dem ersten Anschluss des elektrischen Generators verbunden ist und der zweite Anschluss der Boost-Schaltung mit dem ersten Anschluss der Stromversorgung verbunden ist;
einen Sinuswellenoszillator (16), der zum Erzeugen einer sinusförmigen Spannung mit einer vorgegebenen Frequenz angepasst ist, wobei der Sinuswellenoszillator einen Anschluss aufweist, der mit einer der Einspeiseschaltung und der Boost-Schaltung gekoppelt ist;
einen Stromsensor (21), der zum Erzeugen eines ersten Wechselsignals, das den oszillierenden Strom anzeigt, angepasst ist;
wobei der Stromsensor einen Transformator einschließt, der Folgendes aufweist:
eine Primärspule, die in Reihe zwischen der Boost-Schaltung und dem ersten Anschluss der Stromversorgung geschaltet ist, und
eine Sekundärspule, die mit einem Eingang eines invertierenden oder nicht invertierenden Operationsverstärkers verbunden ist;
einen Spannungssensor (28), der zum Erzeugen eines zweiten Wechselsignals, das die oszillierende Spannung anzeigt, angepasst ist;
einen Quell-Leiter, der zum Übertragen eines dritten Wechselsignals, das die sinusförmige Spannung anzeigt, angepasst ist; und
einen Mikrocontroller (24), der mit dem ersten Wechselsignal, dem zweiten Wechselsignal und dem dritten Wechselsignal gekoppelt ist,
wobei der Mikrocontroller zum Berechnen der Impedanz oder Kapazität der Last durch Verwendung digitaler Daten, die aus dem ersten Wechselsignal, dem zweiten Wechselsignal und dem dritten Wechselsignal abgeleitet werden, angepasst ist.

7. Verfahren nach Anspruch 6, wobei:
die Einspeiseschaltung einen Kopplungskondensator einschließt, der eine Leitung aufweist, die mit dem ersten Anschluss der Stromversorgung verbunden ist;
der Sinuswellenoszillator einen ersten Anschluss, der mit einer anderen Leitung des Kopplungskondensators verbunden ist, und einen zweiten Anschluss aufweist, der mit der Masse oder mit dem zweiten Anschluss der Stromversorgung verbunden ist,
die Boost-Schaltung eine Sperrinduktivität (14) einschließt; und
die Sperrinduktivität zwischen dem ersten Anschluss des elektrischen Generators und dem Kopplungskondensator geschaltet ist.

8. Verfahren nach Anspruch 6, weiter umfassend einen analogen Demodulator (32), der Eingänge aufweist, die mit dem Stromsensor, dem Spannungssensor und dem Quell-Leiter gekoppelt sind,
wobei der analoge Demodulator Ausgänge aufweist, die mit dem Mikrocontroller gekoppelt sind,
wobei der analoge Demodulator ausgebildet ist, um das erste Wechselsignal und das zweite Wechselsignal relativ zum dritten Wechselsignal analog zu demodulieren.

9. Verfahren nach Anspruch 8, wobei der analoge Demodulator einen quadratischen Demodulator einschließt, der ausgebildet ist, um vier Ausgangssignale zu erzeugen:
der Betrag des ersten Wechselsignals multipliziert mit dem Kosinus der Phase des ersten Wechselsignals relativ zum dritten Wechselsignal,
der Betrag des ersten Wechselsignals multipliziert mit dem Sinus der Phase des ersten Wechselsignals relativ zum dritten Wechselsignal,
der Betrag des zweiten Wechselsignals multipliziert mit dem Kosinus der Phase des zweiten Wechselsignals relativ zum dritten Wechselsignal, und
der Betrag des zweiten Wechselsignals multipliziert mit dem Sinus der Phase des zweiten Wechselsignals relativ zum dritten Wechselsignal.

10. Verfahren nach Anspruch 6, wobei der Spannungssensor einschließt
ein Tiefpass- oder Bandpassfilter, das mit dem ersten Anschluss der Stromversorgung und mit der Masse verbunden ist, und
einen invertierenden oder nicht invertierenden Operationsverstärker, der einen Eingang aufweist, der mit dem Tiefpass- oder Bandpassfilter verbunden ist.

11. Verfahren nach Anspruch 6, wobei die Last ein elektrostatisches Spannfutter vom Coulomb-Typ ist, wobei das Verfahren weiter das Klemmen eines Halbleiter- oder Flüssigkristallpanels durch Anlegen einer Gleichstrom-(DC)-Hochspannung an das Spannfutter mit der Stromversorgung umfasst.

## Revendications

1. Alimentation électrique apte à surveiller l'impédance ou la capacité d'une charge (10) reliée à l'alimentation électrique,
l'alimentation électrique incluant :
une première terminaison (26) de connexion à la charge,
un générateur électrique (12) conçu pour générer un courant continu (CC) haute tension entre une première et une deuxième terminaison, dans lequel la première terminaison du générateur électrique est reliée à la première terminaison de l'alimentation électrique et la deuxième terminaison du générateur électrique est reliée à la terre, et
un moniteur (34),
le moniteur comprenant :
un circuit d'injection conçu pour faire circuler un courant oscillant entre une première et une deuxième terminaison, dans lequel la première terminaison du circuit d'injection est reliée à la première terminaison de l'alimentation électrique et la deuxième terminaison du circuit d'injection est reliée à la terre ou à une deuxième terminaison de l'alimentation électrique ;
un circuit de suralimentation conçu pour générer une tension oscillante entre une première et une deuxième terminaison, dans lequel la première terminaison du circuit de suralimentation est reliée à la première terminaison du générateur électrique et la deuxième terminaison du circuit de suralimentation est reliée à la première terminaison de l'alimentation électrique ;
un oscillateur sinusoïdal (16) conçu pour générer une tension sinusoïdale à une fréquence prédéterminée, dans lequel l'oscillateur sinusoïdal présente une terminaison qui est couplée à l'un du circuit d'injection et du circuit de suralimentation ;
un capteur de courant (21) conçu pour générer un premier signal alternatif indiquant le courant oscillant ;
dans laquelle le capteur de courant inclut un transformateur présentant :
une bobine primaire en série entre le circuit de suralimentation et la première terminaison de l'alimentation électrique et
une bobine secondaire reliée à une entrée d'un amplificateur opérationnel inverseur ou non-inverseur ;
un capteur de tension (28) conçu pour générer un deuxième signal alternatif indiquant la tension oscillante ;
un conducteur source conçu pour transmettre un troisième signal alternatif indiquant la tension sinusoïdale ; et
un microcontrôleur (24) couplé au premier signal alternatif, au deuxième signal alternatif et au troisième signal alternatif,
dans laquelle le microcontrôleur est conçu pour calculer l'impédance ou la capacité de la charge en utilisant des données numériques dérivées du premier signal alternatif, du deuxième signal alternatif et du troisième signal alternatif.

2. Alimentation électrique selon la revendication 1, dans laquelle :
le circuit d'injection inclut un condensateur de couplage présentant un fil relié à la première terminaison de l'alimentation électrique ;
l'oscillateur sinusoïdal présente une première terminaison reliée à un autre fil du condensateur de couplage et une deuxième terminaison reliée à la terre ou à la deuxième terminaison de l'alimentation électrique,
le circuit de suralimentation inclut un inducteur de blocage (14) ; et
l'inducteur de blocage est relié entre la première terminaison du générateur électrique et le condensateur de couplage.

3. Alimentation électrique selon la revendication 1, comprenant en outre un démodulateur analogique (32) présentant des entrées couplées au capteur de courant, au capteur de tension et au conducteur source,
le démodulateur analogique présentant des sorties couplées au microcontrôleur,
le démodulateur analogique étant configuré pour démoduler analogiquement le premier signal alternatif et le deuxième signal alternatif par rapport au troisième signal alternatif.

4. Alimentation électrique selon la revendication 3, dans laquelle le démodulateur analogique inclut un démodulateur quadratique configuré pour générer quatre signaux de sortie :
l'amplitude du premier signal alternatif multipliée par le cosinus de la phase du premier signal alternatif par rapport au troisième signal alternatif,
l'amplitude du premier signal alternatif multipliée par le sinus de la phase du premier signal alternatif par rapport au troisième signal alternatif,
l'amplitude du deuxième signal alternatif multipliée par le cosinus de la phase du deuxième signal alternatif par rapport au troisième signal alternatif, et
l'amplitude du deuxième signal alternatif multipliée par le sinus de la phase du deuxième signal alternatif par rapport au troisième signal alternatif.

5. Alimentation électrique selon la revendication 1, dans laquelle le capteur de tension inclut :
un filtre passe-bas ou passe-bande relié à la première terminaison de l'alimentation électrique et à la terre, et
un amplificateur opérationnel inverseur ou non-inverseur présentant une entrée reliée au filtre passe-bas ou passe-bande.

6. Procédé de surveillance de l'impédance ou de la capacité d'une charge (10) reliée à une alimentation électrique,
l'alimentation électrique incluant une première terminaison (26) de connexion à la charge, et un générateur électrique (12) conçu pour générer un courant continu (CC) haute tension entre les première et deuxième terminaisons, dans lequel la première terminaison du générateur électrique est reliée à la première terminaison de l'alimentation électrique et la deuxième terminaison du générateur électrique est reliée à la terre, le procédé comprenant :
la fourniture de l'alimentation électrique avec un moniteur (34) ; et
le déclenchement de l'affichage ou du stockage, sur le moniteur, des données numériques indicatives de l'impédance ou de la capacité de la charge ;
dans lequel le moniteur inclut :
un circuit d'injection conçu pour faire circuler un courant oscillant entre une première et une deuxième terminaison, dans lequel la première terminaison du circuit d'injection est reliée à la première terminaison de l'alimentation électrique et la deuxième terminaison du circuit d'injection est reliée à la terre ou à une deuxième terminaison de l'alimentation électrique ;
un circuit de suralimentation conçu pour générer une tension oscillante entre une première et une deuxième terminaison, dans lequel la première terminaison du circuit de suralimentation est reliée à la première terminaison du générateur électrique et la deuxième terminaison du circuit de suralimentation est reliée à la première terminaison de l'alimentation électrique ;
un oscillateur sinusoïdal (16) conçu pour générer une tension sinusoïdale à une fréquence prédéterminée, dans lequel l'oscillateur sinusoïdal présente une terminaison qui est couplée à l'un du circuit d'injection et du circuit de suralimentation ;
un capteur (21) de courant conçu pour générer un premier signal alternatif indiquant le courant oscillant ;
dans lequel le capteur de courant inclut un transformateur présentant :
une bobine primaire en série entre le circuit de suralimentation et la première terminaison de l'alimentation électrique et
une bobine secondaire reliée à une entrée d'un amplificateur opérationnel inverseur ou non-inverseur ;
un capteur de tension (28) conçu pour générer un deuxième signal alternatif indiquant la tension oscillante ;
un conducteur source conçu pour transmettre un troisième signal alternatif indiquant la tension sinusoïdale ; et
un microcontrôleur (24) couplé au premier signal alternatif, au deuxième signal alternatif et au troisième signal alternatif,
dans lequel le microcontrôleur est conçu pour calculer l'impédance ou la capacité de la charge en utilisant des données numériques dérivées du premier signal alternatif, du deuxième signal alternatif et du troisième signal alternatif.

7. Procédé selon la revendication 6, dans lequel :
le circuit d'injection inclut un condensateur de couplage présentant un fil relié à la première terminaison de l'alimentation électrique ;
l'oscillateur sinusoïdal présente une première terminaison reliée à un autre fil du condensateur de couplage et une deuxième terminaison reliée à la terre ou à la deuxième terminaison de l'alimentation électrique,
le circuit de suralimentation inclut un inducteur de blocage (14) ; et
l'inducteur de blocage est relié entre la première terminaison du générateur électrique et le condensateur de couplage.

8. Procédé selon la revendication 6, comprenant en outre un démodulateur analogique (32) présentant des entrées couplées au capteur de courant, au capteur de tension et au conducteur source,
le démodulateur analogique présentant des sorties couplées au microcontrôleur,
le démodulateur analogique étant configuré pour démoduler analogiquement le premier signal alternatif et le deuxième signal alternatif par rapport au troisième signal alternatif.

9. Procédé selon la revendication 8, dans lequel le démodulateur analogique inclut un démodulateur quadratique configuré pour générer quatre signaux de sortie :
l'amplitude du premier signal alternatif multipliée par le cosinus de la phase du premier signal alternatif par rapport au troisième signal alternatif,
l'amplitude du premier signal alternatif multipliée par le sinus de la phase du premier signal alternatif par rapport au troisième signal alternatif,
l'amplitude du deuxième signal alternatif multipliée par le cosinus de la phase du deuxième signal alternatif par rapport au troisième signal alternatif, et
l'amplitude du deuxième signal alternatif multipliée par le sinus de la phase du deuxième signal alternatif par rapport au troisième signal alternatif.

10. Procédé selon la revendication 6, dans lequel le capteur de tension inclut
un filtre passe-bas ou passe-bande relié à la première terminaison de l'alimentation électrique et à la terre, et
un amplificateur opérationnel inverseur ou non-inverseur présentant une entrée reliée au filtre passe-bas ou passe-bande.

11. Procédé selon la revendication 6, dans lequel la charge est un mandrin électrostatique de type Coulomb, le procédé comprenant en outre le serrage d'un panneau semi-conducteur ou à cristaux liquides en appliquant un courant continu (CC) haute tension au mandrin avec l'alimentation électrique.
